# EUROPÄISCHE PATENTSCHRIFT

(11) **EP 1 117 131 B1**
(45) Veröffentlichungstag und Bekanntmachung des Hinweises auf die Patenterteilung: **26.10.2005**
(21) Anmeldenummer: 00127690.6
(22) Anmeldetag: 18.12.2000
(51) Int. Cl.: H01L 23/544

(54) **Verfahren zur Erzeugung von Justiermarken**
Method of forming alignment marks
Procédé de fabrication pour marques d'alignement

(30) Priorität: 11.01.2000 DE 10000759
(43) Veröffentlichungstag der Anmeldung: 18.07.2001
(73) Patentinhaber: Infineon Technologies AG, 81669 München (DE)
(72) Erfinder: Ebertseder, Eva, 01099 Dresden (DE); Hanebeck, Jochen, 85521 Ottobrunn (DE); Lehr, Matthias, Dr., 01099 Dresden (DE); Pahlitzsch, Jürgen, 01477 Wallroda (DE); Werneke, Torsten, 01324 Dresden (DE)
(74) Vertreter: Epping - Hermann - Fischer

(56) Entgegenhaltungen:
- US-A- 5 898 227
- US-A- 5 933 744
- US-A- 5 935 764
- US-A- 6 008 119

## Beschreibung

Die Erfindung betrifft ein Verfahren zur Erzeugung von Justiermarken bei einer Struktur mit integrierten Schaltkreisen.

Derartige Strukturen mit integrierten Schaltkreisen können insbesondere von DRAM Zellanordnungen gebildet sein, welche in ein Halbleitersubstrat eingearbeitet werden, welches von einem Wafer gebildet ist.

Auf das Halbleitersubstrat werden insbesondere zur Verdrahtung der integrierten Schaltungen mehrere übereinanderliegende Schichten aufgebracht, in welchen Systeme von Leitbahnen aus Metall verlaufen. Hierzu wird insbesondere unmittelbar oder unter Zwischenlagerung weiterer Schichten auf das Halbleitersubstrat eine Isolatorschicht aufgebracht, die insbesondere von einer Oxidschicht gebildet ist. Zur Herstellung der Verbindungen von Leitbahnen werden in diese Isolatorschicht Kontaktlöcher eingeätzt. Die so hergestellten Kontaktlöcher werden dann mit Metall, vorzugsweise Wolfram, gefüllt. Mittels eines CMP-Prozesses (chemisch-mechanisches Polieren) wird dann die Oberfläche der Oxidschicht, insbesondere über die oberen Ränder der Kontaktlöcher hervorstehendes Metall, eben poliert. Anschließend wird auf die Oxidschicht eine Metallschicht aufgebracht. Zur Strukturierung dieser Metallschicht wird anschließend eine Lackmaske aufgebracht.

Ein Problem hierbei besteht darin, dass die Lackmaske auf der Metallschicht genau ausgerichtet werden muss. Insbesondere muss die Lackmaske auf die Struktur der Leiterbahnen in der Oxidschicht ausgerichtet werden. Da jedoch die Metallschicht undurchsichtig ist, können die Strukturen in der Oxidschicht nicht auf direktem Wege optisch erfasst werden. Daher sind die Justiermarken in der Metallschicht als lokale Vertiefungen angeordnet, welche mittels optischer Messgeräte wie zum Beispiel Laserinterferometern erfassbar sind.

Zur Herstellung derartiger Justiermarken werden an vorgegebenen Stellen in die Oxidschicht Justiergräben eingeätzt. Diese Justiergräben werden zusammen mit den Kontaktlöchern in die Oxidschicht eingeätzt. Danach werden mit den Kontaktlöchern auch die Justiergräben mit Metall gefüllt, worauf die Oberflächenbearbeitung mittels des CMP-Prozesses erfolgt.

Die Breiten der Justiergräben sind erheblich größer als die Breiten der Kontaktlöcher. Typischerweise beträgt die Breite eines Kontaktloches etwa 0,3 µm, während die Breite eines Justiergrabens etwa 2 µm beträgt.

Dies hat zur Folge, dass durch den Druck auf die Oberseiten der Metallschichten bei dem Poliervorgang des CMP-Prozesses die Metalloberflächen der Metallschichten in den Justiergräben abgesenkt werden, nicht jedoch die Metalloberflächen der Metallschichten in den Kontaktlöchern. Dies beruht darauf, dass die Metallschicht, insbesondere bei Verwendung von Wolfram, weicher als die Oxidschicht ist. Bei den geringen Breiten der Kontaktlöcher übt die Oxidschicht während des Poliervorgangs eine Stützwirkung aus, die sich über die gesamte Fläche eines Kontaktloches erstreckt. Da die Breiten der Justiergräben erheblich größer als die Breiten der Kontaktlöcher sind, wirkt sich die Stützwirkung der Oxidschicht nur in den Randbereichen der Justiergräben aus, so dass in der Mitte der Justiergräben während des CMP-Prozesses jeweils eine Absenkung der Metalloberfläche entsteht.

Diese Absenkungen bilden Profile für die Justiermarken, wobei die Justiermarken nach Abscheiden der Metallschicht oberhalb der Justiergräben liegen. Dabei sind die Justiermarken als Vertiefungen ausgebildet, die im wesentlichen den zuvor erzeugten Profilen entsprechen.

Damit die Justiermarken von den jeweiligen optischen Messgeräten erfasst werden können, müssen die Übergänge der ebenen Metalloberfläche zu den die Justiermarken bildenden Vertiefungen in den Randbereichen möglichst steil abfallen. Des weiteren müssen die Justiermarken reproduzierbar herstellbar sein, damit diese sicher von den Messgeräten erfassbar sind. Es hat sich gezeigt, dass bei bekannten derartigen Justiermarken diese Forderungen nur unzureichend erfüllbar sind.

Ein wesentliches Problem besteht bei der Herstellung derartiger Justiermarken darin, dass die Absenkung der Metalloberfläche bei dem CMP-Prozess nicht reproduzierbar herstellbar ist. Dementsprechend schwanken für verschiedene Fertigungslose die Profile der die Justiermarken bildenden Vertiefungen, wodurch deren Messung erschwert oder verfälscht wird. Ein weiteres Problem besteht darin, das sich während des CMP-Prozesses Poliermittelreste in den Absenkungen der Metallschichten der Justiergräben ablagern. Aufgrund der mangelnden Reproduzierbarkeit bei der Ausbildung der Absenkungen weisen deren Oberflächen Unregelmäßigkeiten auf, in welchen sich die Poliermittelreste so festsetzen, dass diese nicht mehr entfernbar sind. Dabei setzen sich die Poliermittelreste insbesondere in den Randbereichen der Absenkungen fest. Dies wiederum führt dazu, dass die Profile der Absenkungen in den Randbereichen nicht mehr die erforderliche Steilheit aufweisen, so dass dementsprechend bei den Justiermarken nur noch flach abfallende Ränder erhalten werden. Dadurch können die Justiermarken mit den Messgeräten nicht mehr hinreichend sicher erfasst werden.

In der US 5,869,383 ist ein Verfahren zur Erzeugung von Justiermarken, die zur Ausrichtung eines Lasers an einem Halbleitersubstrat verwendet werden, beschrieben. Das Halbleitersubstrat besteht aus einem Silizium-Wafer und weist eine Anordnung von integrierten Schaltkreisen auf, die beispielsweise eine DRAM Zellanordnung bilden. Damit bei der Herstellung derartiger DRAM Zellanordnungen anfallende defekte Schaltkreise nicht zu einer mangelhaften Funktion der gesamten DRAM Zellanordnung führen, ist wenigstens ein Teil der Schaltkreise redundant ausgebildet. Ist einer der doppelt vorgesehenen Schaltkreise defekt, so wird dieser deaktiviert und der zugeordnete, entsprechende Schaltkreis wird aktiviert.

Die Deaktivierung bestimmter Schaltkreise erfolgt mittels des Lasers dadurch, dass ein auf dem Halbleitersubstrat aufgebrachtes schmelzbares Schichtsegment aufgeschmolzen wird. Vorzugsweise besteht dieses Schichtsegment aus Polysilizium. Dieses Polysiliziumschichtsegment ist unter Zwischenlagerung einer Isolatorschicht auf das Halbleitersubstrat aufgebracht. Auf die Polysiliziumschichtsegmente und das Halbleitersubstrat sind mehrere dielektrische Zwischenschichten aufgebracht.

Auf diese dielektrischen Zwischenschichten wird eine Passivierungsschicht aus Siliziumoxid oder Siliziumnitrid aufgebracht, deren Schichtdicke im Bereich zwischen 200 nm und 1000 nm liegt.

Auf diese Passivierungsschicht wird eine Resistschicht zur Bildung einer Lackmaske aufgebracht. Mittels eines Photolithographieprozesses wird ein Lochmuster in der Resistschicht erzeugt. Mittels eines Ätzprozesses, vorzugsweise eines RIE (reactive-ion-etching)-Verfahrens werden durch die Löcher der Lackmaske Ausnehmungen in den dielektrischen Zwischenschichten erzeugt. Diese Ausnehmungen liegen oberhalb den Polysiliziumschichtsegmenten, wobei die Tiefen der Ausnehmungen so gewählt sind, dass der Boden einer Ausnehmung jeweils dicht oberhalb des jeweiligen Polysiliziumschichtsegments liegt. Zur Deaktivierung von integrierten Schaltkreisen werden dann die vom Laser emittierten Laserstrahlen in die jeweiligen Ausnehmungen geführt, wodurch die darunter liegenden Polysiliziumschichtsegmente aufgeschmolzen werden.

Die Ausrichtung des Lasers erfolgt mittels der Justiermarken. Zur Herstellung der Justiermarken werden an vorgegebenen Stellen auf die Oberfläche der obersten dielektrischen Zwischenschicht eine Metallschicht aufgebracht. Auf diese Metallschicht wird dann eine Antireflexschicht aufgebracht. Anschließend wird die Passivierungsschicht auf das gesamte Substrat aufgebracht, welche die freiliegenden Teile der obersten dielektrischen Zwischenschicht und auch die Metallschicht mit der darauf liegenden Antireflexschicht bedeckt.

Auf diese Antireflexschicht wird dann die Resistschicht aufgebracht. Bei dem Photolithographieprozess zur Erzeugung der Lochmuster wird in der Resistschicht ein Lochmuster erzeugt, mit welchem bei dem nachfolgenden Ätzprozess nicht nur die Ausnehmungen in den dielektrischen Zwischenschichten oberhalb der Polysiliziumschichtsegmente erzeugt werden, sondern auch Ausnehmungen in der Passivierungsschicht und der Antireflexschicht oberhalb der Metallschicht. Diese Ausnehmungen werden bis zur Oberfläche der Metallschicht durchgeätzt und bilden die Justiermarken.

Aus der US 5,270,255 ist ein weiteres Verfahren zur Erzeugung von Justiermarken bekannt. Dort wird auf ein Halbleitersubstrat mit integrierten Schaltungen eine Isolatorschicht aufgebracht, in welche Kontaktlöcher zur Erzeugung von Leitbahnen zur Verdrahtung von integrierten Schaltkreisen im Halbleitersubstrat eingeätzt werden. Zusätzlich zu den Kontaktlöchern werden auch Justiergräben in die Isolatorschicht zur Erzeugung der Justiermarken eingeätzt.

Anschließend wird in einem ersten Sputterprozess eine TiN-Schicht auf die Isolatorschicht aufgebracht. Die Schichtdicke dieser Schicht beträgt etwa 100 nm bis 500 nm, so dass nach Aufbringen dieser Schicht die Profile der Justiergräben und Kontaktlöcher noch weitgehend erhalten sind.

In einem zweiten Sputterprozess erfolgt die Auftragung einer Metallschicht, deren Schichtdicke nur etwa 150 nm bis 200 nm beträgt, so dass auch nach Aufbringen dieser Schicht die Profile der Kontaktlöcher und Justiergräben noch weitgehend erhalten sind.

Anschließend wird in einem dritten Sputterprozess eine weitere Metallschicht aufgebracht, deren Schichtdicke im Bereich von 200 nm bis 400 nm liegt. Diese Schichtdicke ist so gewählt, dass dabei die Kontaktlöcher, die eine geringere Breite als die Justiergräben aufweisen, nahezu komplett mit Metall befüllt werden. Die Justiergräben werden jedoch nur teilweise mit Metall befüllt, so dass in deren Bereichen jeweils an der Oberfläche muldenförmige Vertiefungen entstehen.

Durch Aufbringen einer letzten Metallschicht wird durch geeignete Wahl des Sputterprozesses erreicht, dass die Vertiefungen oberhalb der Justiergräben deutlicher profiliert werden und insbesondere in den Randbereichen deutlich ausgebildete Kanten aufweisen.

Diese profilierten Vertiefungen in der obersten Metallschicht bilden die Justiermarken, mittels derer beispielsweise eine Lackmaske auf der Metallschicht ausgerichtet werden kann.

In der US 5 663 099 A ist ein Verfahren zum Erzeugen von Justiermarken beschrieben, bei dem eine Isolatorschicht auf dem Halbleitersubstrat aufgebracht wird. Es werden Kontaktlöcher und Justiergräben in die Isolatorschicht eingeätzt, welche an Ihrer Unterseite auf dem Halbleitersubstrat münden. Die Kontaktlöcher und Justiergräben werden mit Metall gefüllt. Die Oberfläche der Isolatorschicht wird nachfolgend behandelt. Eine zweite Metallschicht wird auf der Isolatorschicht abgeschieden, wobei an der Oberseite der Metallschicht im Bereich der Justiergräben lokale Vertiefungen entstehen. Die Vertiefungen bilden die Justiermarken.

In der US 5 786 260 A ist allgemein die Verwendung von chemisch-mechanischem Polieren bei der Erzeugung von Justiermarken beschrieben.

Der Erfindung liegt die Aufgabe zugrunde ein Verfahren der eingangs genannten Art so auszubilden, dass die dabei erzeugten Justiermarken mit geringem Aufwand herstellbar und gleichzeitig von Messgeräten sicher erfassbar sind.

Zur Lösung dieser Aufgabe sind die Merkmale des Anspruchs 1 vorgesehen. Vorteilhafte Ausführungsformen und zweckmäßige Weiterbildungen der Erfindung sind in den Unteransprüchen beschrieben.

Bei dem erfindungsgemäßen Verfahren erfolgt die Erzeugung von Justiermarken zusammen mit der Herstellung von Leitbahnen zur Verdrahtung von integrierten Schaltkreisen in einem Halbleitersubstrat.

In einem ersten Verfahrensschritt wird eine erste Metallschicht über dem Halbleitersubstrat mit den integrierten Schaltungen aufgebracht.

Anschließend erfolgt ein Aufbringen einer Isolatorschicht auf die erste Metallschicht.

Danach erfolgt ein Einätzen von Kontaktlöchern und Justiergräben in die Isolatorschicht, wobei die Kontaktlöcher und Justiergräben an ihrer Unterseite an der Metallschicht ausmünden. Die Kontaktlöcher dienen zur Herstellung von Verbindungen von Leitbahnen zur Verdrahtung der integrierten Schaltungen.

Darauf erfolgt ein Einbringen von Metall in die Justiergräben und die Kontaktlöcher und eine nachfolgende Behandlung der Oberfläche der Isolatorschicht durch chemisch-mechanisches Polieren (CMP), wobei die Metalloberflächen im Bereich der Justiergräben abgesenkt werden und Profile für die Justiermarken bilden.

Schließlich erfolgt ein Abscheiden einer zweiten Metallschicht auf der Isolatorschicht, wobei die Metallschicht im Bereich der Justiergräben entsprechend den jeweiligen Profilen lokale Vertiefungen aufweist, welche die Justiermarken bilden.

Ein wesentlicher Vorteil des erfindungsgemäßen Verfahrens besteht darin, dass die Erzeugung der Justiermarken zusammen mit der Herstellung der Verbindungen von Leitbahnen zur Verdrahtung der integrierten Schaltungen im Halbleitersubstrat erfolgt, wobei für die Erzeugung der Justiermarken keine zusätzlichen Prozessschritte erforderlich sind. Des weiteren ist vorteilhaft, dass die Justiermarken in der Metallschicht oberhalb der Isolatorschicht mit den Kontaktlöchern eingearbeitet werden können, ohne dass dabei eine Zwischenlagerung von weiteren Schichten notwendig wird. Demzufolge können die Justiermarken mit einem Minimum an prozesstechnischem Aufwand erzeugt werden.

Trotz des geringen Herstellungsaufwandes sind die Justiermarken so ausgebildet, dass diese mit optischen Messgeräten sicher erfassbar sind. Ein wesentlicher Grund hierfür ist, dass mit dem erfindungsgemäßen Verfahren die Justiermarken mit hoher Reproduzierbarkeit gefertigt werden können. Diese hohe Reproduzierbarkeit wird insbesondere dadurch erhalten, dass unterhalb der Justiergräben in der Isolatorschicht die Metallschicht vorgesehen ist. Diese Metallschicht dient als Ätzstopp bei der Ätzung der Justiergräben, so dass die Oberflächen der Metallschicht reproduzierbare ebene Böden der Justiergräben bilden.

Dadurch wird erreicht, dass nach dem Einbringen von Metall in die Justiergräben durch das chemisch-mechanische Polieren eine entsprechend regelmäßige und reproduzierbare Absenkung der Metalloberfläche im Bereich der Justiergräben erhalten wird. Dementsprechend verbleiben an diesen Absenkungen beim chemisch-mechanischen Polieren keine Poliermittelreste, welche die Profile der Absenkungen unerwünscht beeinträchtigen. Insbesondere wird vermieden, dass sich Poliermittelreste an den Rändern der Absenkungen ablagern. Somit wird durch das chemisch-mechanische Polieren eine Absenkung des Metalls im Bereich der Justiergräben erhalten, welche an den Rändern einen steilen Übergang zu der ebenen Oberfläche der Isolatorschicht bildet.

Besonders vorteilhaft sind die Breiten der Justiergräben erheblich größer als die Breiten der Kontaktlöcher. Die Breiten der Kontaktlöcher sind dabei so klein gewählt, dass bei dem chemisch-mechanischen Polieren der Oberfläche des Metalls in den Kontaktlöchern die härtere Isolatorschicht eine Stützwirkung für das weichere Metall in den Kontaktlöchern ausübt, die sich über die gesamte Fläche eines Kontaktloches erstreckt. Dies hat zur Folge, dass während des chemisch-mechanischen Polierens die Oberfläche des Metalls in den Kontaktlöchern nicht oder nur sehr wenig abgesenkt wird.

Demgegenüber sind die Breiten der Justiergräben so groß gewählt, dass sich die Stützwirkung der umgebenden Isolatorschicht nur in den Randbereichen der Justiergräben auswirkt. Somit wird die Oberfläche des Metalls in den Justiergräben abgesenkt, wobei der Grad der Absenkung durch die Prozessparameter des chemisch-mechanischen Polierens und die Breiten der Justiergräben vorgebbar ist.

In einer besonders vorteilhaften Ausführungsform umfasst das chemisch-mechanische Polieren einen Ätzprozess. Bei diesem Ätzprozess wird eine dünne Oberflächenschicht der Isolatorschicht abgetragen. Dadurch wird erreicht, dass die Metallflächen im Bereich der Kontaktlöcher geringfügig über die Oberfläche der Isolatorschicht hervorstehen. Die Absenkungen der Metallflächen im Bereich der Justiergräben weisen jedoch eine so große Tiefe auf, dass diese von dem Ätzprozess nahezu unbeeinträchtigt bleiben.

Nach dem chemisch-mechanischen Polieren wird eine Metallschicht auf die Isolatorschicht aufgebracht, wobei entsprechend den Profilen der Absenkungen im Bereich der Justiergräben an der Oberseite der Metallschicht entsprechende Vertiefungen erhalten werden. Diese die Justiermarken bildenden Vertiefungen weisen regelmäßige und insbesondere im Randbereich steile Profile auf und können daher mittels optischer Messgeräte sicher erfasst werden. Da zur Bildung dieser Vertiefungen die Metallschicht unmittelbar auf die Absenkungen des Metalls in den Justiergräben aufgebracht wird, sind die Vertiefungen mit einer den Absenkungen entsprechenden hohen Reproduzierbarkeit herstellbar.

Mit den so hergestellten Justiermarken kann insbesondere eine Lackmaske, die auf die Metallschicht aufgebracht wird, relativ zu dieser Metallschicht justiert werden.

Die Erfindung wird im nachstehenden anhand der Zeichnungen erläutert. Es zeigen:

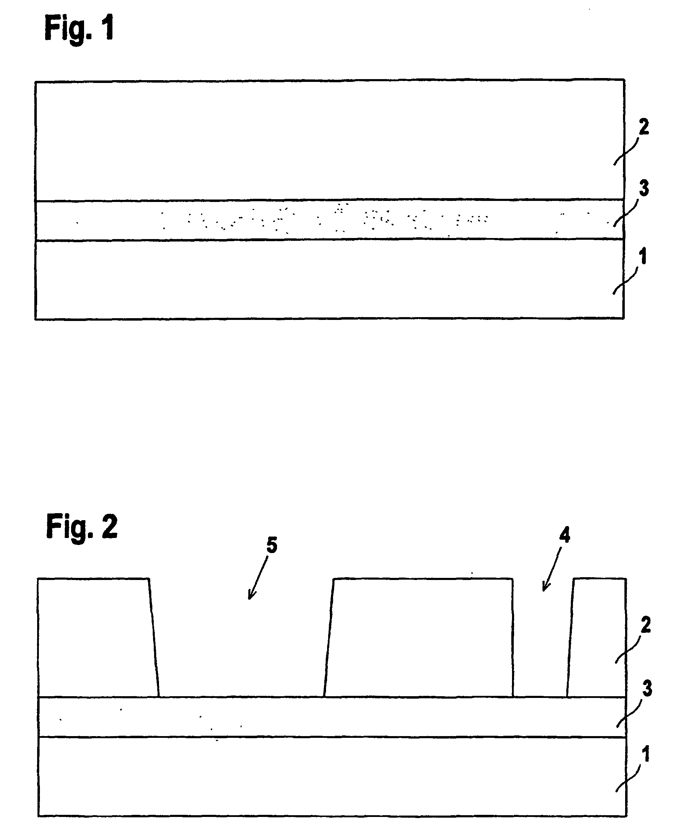

Figur 1 bis 4: Schematische Darstellung der einzelnen Verfahrensschritte zur Erzeugung von Justiermarken bei einer Struktur mit integrierten Schaltungen.

In den Figuren 1 bis 4 ist schematisch ein Ausführungsbeispiel des erfindungsgemäßen Verfahrens zur Erzeugung von Justiermarken dargestellt.

In Figur 1 ist ein Ausschnitt eines Halbleitersubstrats 1 dargestellt, in welchem eine Anordnung von nicht dargestellten integrierten Schaltungen vorgesehen ist. Das Halbleitersubstrat 1 ist vorzugsweise von einem Silizium-Wafer gebildet. Bei den integrierten Schaltungen handelt es sich im vorliegenden Ausführungsbeispiel um eine DRAM Zellanordnung.

Die integrierten Schaltungen werden über ein System von Leitbahnen verdrahtet. Zur Erzeugung von Verbindungen zwischen diesen Leitbahnen wird oberhalb des Halbleitersubstrats 1 eine Isolatorschicht 2 aufgebracht. Die Isolatorschicht 2 ist vorzugsweise von einer Oxidschicht gebildet. Beispielsweise wird als Oxid SiO₂ verwendet. Die Schichtdicke der Oxidschicht beträgt im vorliegenden Ausführungsbeispiel etwa 500 nm.

Prinzipiell können auch mehrere Isolatorschichten 2 vorgesehen sein, welchen gegebenenfalls weitere Schichten zwischengelagert sind.

Erfindungsgemäß ist zwischen dem Halbleitersubstrat 1 und der Isolatorschicht 2 eine erste Metallschicht 3 vorgesehen. Die Metallschicht 3 besteht vorzugsweise aus Wolfram oder AlCu. Die Schichtdicke dieser Metallschicht 3 ist beträchtlich kleiner als die Schichtdicke der Isolatorschicht 2. Wesentlich hierbei ist, dass die Metallschicht 3 eine ebene, reproduzierbar herstellbare Oberfläche aufweist.

Entsprechend der Anordnung, der zu erzeugenden Verbindungen zwischen den einzelnen Leitbahnen werden in die Isolatorschicht 2 Kontaktlöcher 4 eingeätzt. Diese Kontaktlöcher 4 durchsetzen die Oxidschicht vollständig, so dass deren Unterseiten an der Oberseite der Metallschicht 3 ausmünden.

Mit der Ätzung der Kontaktlöcher 4 werden gleichzeitig auch Justiergräben 5 in die Isolatorschicht 2 eingeätzt. Diese Justiergräben 5 dienen zur Erzeugung von Justiermarken. Auch die Justiergräben 5 durchsetzen die Isolatorschicht 2 vollständig, so dass die Unterseiten der Justiergräben 5 an der Oberseite der ersten Metallschicht 3 ausmünden.

In Figur 2 sind schematisch ein Justiergraben 5 und ein Kontaktloch 4 dargestellt. Diese Darstellung ist insofern nicht maßstäblich, dass die Justiergräben 5 nicht unmittelbar neben den Kontaktlöchern 4 angeordnet sind. Während die Kontaktlöcher 4 im Nutzbereich des Wafers liegend zur Verdrahtung der integrierten Schaltungen angeordnet sind, liegen die Justiergräben 5 im Bereich des Sägerahmens des Wafers, welcher nach der Bearbeitung des Wafers als Ausschuss anfällt.

Da die Kontaktlöcher 4 ebenso wie die Justiergräben 5 an der Oberseite der Metallschicht 3 ausmünden, weisen diese dieselbe Tiefe auf. Dagegen sind die Breiten der Justiergräben 5 erheblich größer als die Breiten der Kontaktlöcher 4. Typischerweise betragen die Breiten der Kontaktlöcher 4 etwa 0,3 µm, während die Breiten der Justiergräben 5 etwa 2 µm betragen.

Nach dem Ätzprozess erfolgt eine Abscheidung von Metall 6 in den einzelnen Justiergräben 5 und Kontaktlöchern 4. Als Metall 6 wird hierbei vorzugsweise Wolfram verwendet. Bei diesem Prozess stehen üblicherweise kleine Reste von Metall 6 über die Oberkanten der Justiergräben 5 und Kontaktlöcher 4 hervor und bedecken zudem die Oberseiten der Isolatorschicht 2.

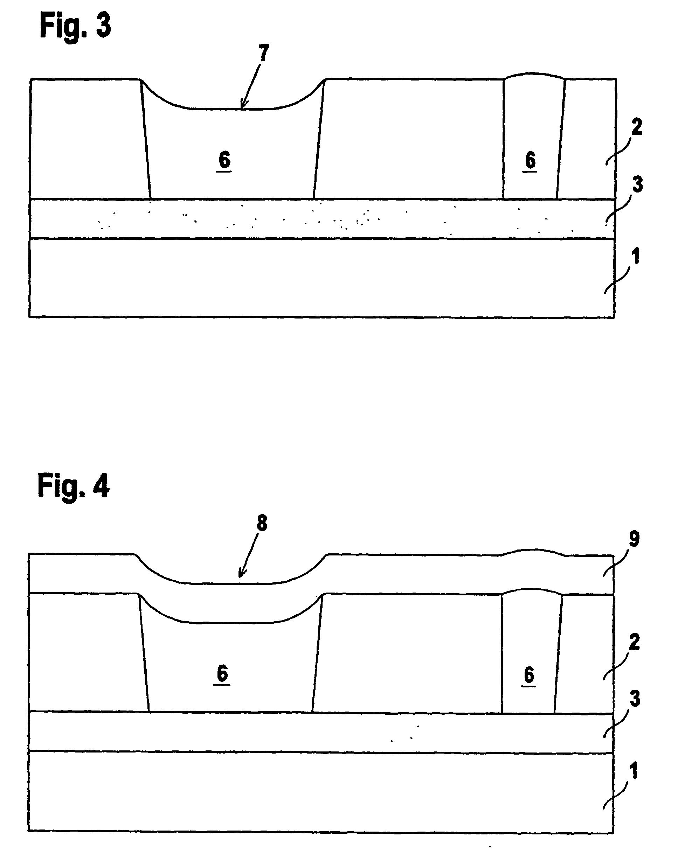

Daher erfolgt anschließend durch chemisch-mechanisches Polieren eine Polierung der Oberseite der Isolatorschicht 2 und insbesondere eine Polierung der Oberseiten der mit Metall 6 befüllten Justiergräben 5 und Kontaktlöcher 4. Figur 3 zeigt die so bearbeitete Oberseite der Isolatorschicht 2.

Wie aus Figur 3 ersichtlich, steht die Oberseite des in ein Kontaktloch 4 befüllten Metalls 6 geringfügig über die Oberseite der Isolatorschicht 2 hervor. Demgegenüber wird durch das chemisch-mechanische Polieren bei dem in den Justiergräben 5 eingefüllten Metall 6 an der Oberseite eine Absenkung 7 erhalten.

Diese Struktur wird durch eine geeignete Ausbildung des Prozessablaufs bei dem chemisch-mechanischen Polieren erhalten. Zunächst erfolgt ein mechanisches Polieren der Oberfläche der Isolatorschicht 2 sowie der Oberflächen des Metalls 6, welches in die Kontaktlöcher 4 und Justiergräben 5 abgeschieden wurde. Da das Metall 6 in den Justiergräben 5 und in den Kontaktlöchern 4 erheblich weicher ist als die Isolatorschicht 2, gibt das Metall 6 unter dem Druck des Polierens nach, nicht jedoch die Isolatorschicht 2. Dadurch wird die Metalloberfläche gegenüber der Oberfläche der Isolatorschicht 2 abgesenkt.

Die Breiten der Kontaktlöcher 4 sind so gewählt, dass die umgebende Isolatorschicht 2 über die gesamte Breite eines Kontaktloches 4 eine Stützwirkung auf das Metall 6 ausübt, so dass ein Absenken der Metalloberfläche vollständig oder nahezu vollständig vermieden wird.

Dagegen sind die Breiten der Justiergräben 5 erheblich größer, so dass sich in diesem Fall die Stützwirkung auf die Randbereiche des Metalls 6 beschränkt. Im Zentrum der Justiergräben 5 wird jedoch das Metall 6 durch den Polierprozess stark abgesenkt. Wie aus Figur 3 ersichtlich, sind die Profile der Absenkungen 7 derart ausgebildet, dass im Randbereich ein steiler Abfall der Metalloberfläche erhalten wird. Im Zentrum ist die Absenkung 7 in Form einer flach verlaufenden Mulde ausgebildet. Die Tiefe der Absenkung 7 lässt sich im wesentlichen durch den beim Polieren ausgeübten Druck bestimmen.

In einem weiteren Prozessschritt wird anschließend die Oberfläche der Isolatorschicht 2 chemisch behandelt. Dadurch wird eine dünne Oberflächenschicht der Isolatorschicht 2 abgeätzt. Die Abtragung an der Oberseite der Isolatorschicht 2 ist so gewählt, dass die Metallflächen im Bereich der Kontaktlöcher 4 wie in Figur 3 dargestellt geringfügig über die Oberseite der Isolatorschicht 2 hervorstehen. Die Absenkungen 7 der Metallschicht 3 in den Justiergräben 5 bleiben hiervon jedoch nahezu unberührt.

Da die Böden der Justiergräben 5 von den ebenen Oberseiten der Metallschicht 3 gebildet sind, weisen die Justiergräben 5 eine konstante, gleichbleibende Tiefe auf. Vorteilhaft hierbei ist insbesondere, dass die Tiefen der Justiergräben 5 durch die Verwendung der Metallschicht 3 mit einer hohen Reproduzierbarkeit erzeugt werden können.

Entsprechend kann auch die Befüllung der Justiergräben 5 mit Metall 6 mit einer hohen Reproduzierbarkeit durchgeführt werden, so dass auch die Absenkungen 7 an den Oberseiten der Befüllung regelmäßige und reproduzierbare Flächenprofile bilden. Daher lagern sich während des chemisch-mechanischen Polierens keine bleibenden Poliermittelreste auf den Absenkungen 7 an, die zu lokalen Störungen der Flächenprofile der Absenkungen 7 führen würden.

Wie aus Figur 4 ersichtlich, wird in einem abschließenden Verfahrensschritt auf die Isolatorschicht 2 eine zweite Metallschicht 9 aufgebracht, die vorzugsweise aus Wolfram besteht. Die Schichtdicke dieser zweiten Metallschicht 9 beträgt vorzugsweise etwa 300 nm.

Die Oberseite dieser Metallschicht 9 verläuft im Bereich der Isolatorschicht 2 in einer horizontalen Ebene parallel zur Oberseite der Metallschicht 9. Im Bereich der Kontaktlöcher 4 verläuft die Oberseite der Metallschicht 9 etwas erhöht, wobei diese Erhöhung etwa dem Überstand der Oberfläche des Metalls 6 über die Isolatorschicht 2 in den Kontaktlöchern 4 entspricht. Im Bereich der Justiergräben 5 wird diese Metallschicht 9 auf die Absenkungen 7 aufgetragen, so dass sich dort an der Oberseite der Metallschicht 9 Vertiefungen 8 bilden.

Diese Vertiefungen 8 bilden die Justiermarken. Dabei entsprechen deren Flächenprofile mit hoher Übereinstimmung den flächenprofilen der Absenkungen 7 an den Oberseiten der Justiergräben 5. Entsprechend den vorhergehenden Bearbeitungsschritten können die Vertiefungen 8 mit einer hohen Reproduzierbarkeit hergestellt werden. Wesentlich dabei ist, dass in den Randbereichen der Vertiefungen 8 entsprechend den Absenkungen 7 ein steiler Abfall erhalten wird. Dadurch können die Justiermarken mittels optischer Messgeräte, wie zum Beispiel Laserinterferometern, sicher erfasst werden.

Die Justiermarken können dabei als sogenannte Alignment-Marken oder als sogenannte Overlay-Marken ausgebildet sein. Alignment-Marken dienen dabei dazu, um verschiedene Schichtebenen relativ zueinander zu justieren. Overlay-Marken dienen dazu Lagefehler in Schichtebenen zu bestimmen. Beispielsweise kann mittels Overlay-Marken der Lagefehler zu der Isolatorschicht 2 mit den Kontaktlöchern 4 bestimmt werden.

Im vorliegenden Ausführungsbeispiel dienen die Justiermarken dazu, um eine Lackmaske, die auf die Metallschicht 9 aufgebracht wird, relativ zu dieser Metallschicht 9 zu justieren.

Eine derartige Lackmaske weist eine Resistschicht auf, in welche mittels eines Photolithographieverfahrens ein Lochmuster eingearbeitet wird. Hierzu werden die Halbleitersubstrate 1 zur Belichtung vorgegebener Stellen der Resiststrukturen mittels eines Steppers in geeigneter Weise zur Belichtungsquelle positioniert. Diese Positionierung wird mit den erfindungsgemäßen Justiermarken durchgeführt.

## Patentansprüche

1. Verfahren zur Erzeugung von Justiermarken bei einer Struktur mit integrierten Schaltkreisen umfassend folgende Verfahrensschritte:
Aufbringen einer ersten eine Oberfläche aufweisenden Metallschicht (3) über einem Halbleitersubstrat (1) mit integrierten Schaltungen,
Aufbringen einer Isolatorschicht (2) auf der ersten Metallschicht (3), wobei die Schichtdicke der ersten Metallschicht (3) wesentlich kleiner als die Schichtdicke der Isolatorschicht (2) ist,
Einätzen von Kontaktlöchern (4) und Justiergräben (5) in die Isolatorschicht (2), wobei die Kontaktlöcher (4) und die Justiergräben (5) an ihrer Unterseite jeweils an der ersten Metallschicht (3) ausmünden und die Breiten der Justiergräben (5) wesentlich größer sind als die Breiten der Kontaktlöcher (4),
Auffüllen mit Metall (6) der Justiergräben (5) und der Kontaktlöcher (4) und nachfolgende Behandlung der Oberfläche der Isolatorschicht (2) und des Metalls (6) durch chemisch-mechanisches Polieren (CMP), wobei die Metallflächen im Bereich der Justiergräben (5) abgesenkt werden und Profile für die Justiermarken bilden,
Abscheiden einer zweiten Metallschicht (9) auf der Isolatorschicht (2) und dem Metall (6), wobei an der Oberseite der zweiten Metallschicht (9) im Bereich der Justiergräben (5) entsprechend.den jeweiligen Profilen lokale Vertiefungen (8) entstehen, welche die Justiermarken bilden.

2. Verfahren nach Anspruch 1, **dadurch gekennzeichnet**, dass das chemisch-mechanische Polieren einen Ätzprozess umfasst, bei welchem eine dünne Oberflächenschicht der Isolatorschicht 2 abgetragen wird, so dass die Metallflächen im Bereich der Kontaktlöcher (4) geringfügig über die Oberseite der Isolatorschicht (2) hervorstehen.

3. Verfahren nach einem der Ansprüche 1 oder 2, **dadurch gekennzeichnet, dass** die erste Metallschicht (3) aus Wolfram oder AlCu besteht.

4. Verfahren nach einem der Ansprüche 1 - 3, **dadurch gekennzeichnet, dass** die Justiergräben (5) und Kontaktlöcher (4) mit Wolfram aufgefüllt werden.

5. Verfahren nach einem der Ansprüche 1 - 4, **dadurch gekennzeichnet, dass** die zweite Metallschicht (9) aus Wolfram besteht.

6. Verfahren nach einem der Ansprüche 1 - 5, **dadurch gekennzeichnet, dass** die Isolatorschicht (2) aus einer Oxidschicht besteht.

7. Verfahren nach Anspruch 6, **dadurch gekennzeichnet, dass** die Oxidschicht aus SiO₂ besteht.

8. Verfahren nach einem der Ansprüche 1 - 7, **dadurch gekennzeichnet, dass** die zweite Metallschicht (9) eine Schichtdicke von etwa 300 nm aufweist.

9. Verfahren nach einem der Ansprüche 1 - 8, **dadurch gekennzeichnet, dass** die Isolatorschicht (2) eine Schichtdicke von etwa 500 nm aufweist.

10. Verfahren nach einem der Ansprüche 1 - 9,
**dadurch gekennzeichnet, daß**
die Breiten der Kontaktlöcher (4) erheblich kleiner als die Breiten der Justiergräben (5) sind.

11. Verfahren nach Anspruch 10,
**dadurch gekennzeichnet, daß**
die Breiten der Justiergräben (5) etwa 2 µm betragen.

12. Verfahren nach einem der Ansprüche 10 oder 11,
**dadurch gekennzeichnet, daß**
die Breiten der Kontaktlöcher (4) etwa 0,3 µm betragen

13. Verfahren nach einem der Ansprüche 1 - 12,
**dadurch gekennzeichnet, daß**
die Justiermarken als Alignment-Marken oder als Overlay-Marken ausgebildet sind.

14. Verfahren nach einem der Ansprüche 1 - 13,
**dadurch gekennzeichnet, daß**
die Justiermarken im Sägerahmen eines das Halbleitersubstrat 1 bildenden Wafers angeordnet sind.

15. Verfahren nach Anspruch 14,
**dadurch gekennzeichnet, daß**
mittels der Justiermarken eine Justierung einer Lackmaske auf die zweite Metallschicht (9) erfolgt.

16. Verfahren nach Anspruch 15,
**dadurch gekennzeichnet, daß**
mittels der Justiermarken der Lagefehler zu der Ebene mit den Kontaktlöchern (4) bestimmt wird.

17. Verfahren nach einem der Ansprüche 1 - 16,
**dadurch gekennzeichnet, daß**
die integrierten Schaltungen im Halbleitersubstrat (1) von einer DRAM Zellanordnung gebildet sind.

## Claims

1. Method for producing alignment markers in a structure with integrated circuits, comprising the following method steps:
application of a first metal layer (3), having a surface, over a semiconductor substrate (1) with integrated circuits,
application of an insulator layer (2) on the first metal layer (3), the layer thickness of the first metal layer (3) being significantly less than the layer thickness of the insulator layer (2),
etching of contact holes (4) and alignment trenches (5) into the insulator layer (2), the contact holes (4) and the alignment trenches (5) in each case opening out at the first metal layer (3) at their underside and the widths of the alignment trenches (5) being significantly greater than the widths of the contact holes (4),
Filling of the alignment trenches (5) and the contact holes (4) with metal and subsequent treatment of the surface of the insulator layer (2) and of the metal (6) by chemical mechanical polishing (CMP), the metal areas being lowered in the region of the alignment trenches (5) and forming profiles for the alignment markers,
deposition of a second metal layer (9) on the insulator layer (2) and the metal (6), local depressions (8) arising on the top side of the second metal layer (9) in the region of the alignment trenches (5) in accordance with the respective profiles, said depressions forming the alignment markers.

2. Method according to Claim 1, **characterized in that** the chemical mechanical polishing comprises an etching process in which a thin surface layer of the insulator layer (2) is removed, so that the metal areas in the region of the contact holes (4) project slightly above the top side of the insulator layer (2).

3. Method according to either of Claims 1 and 2, **characterized in that** the first metal layer (3) is composed of tungsten or AlCu.

4. Method according to one of Claims 1 - 3, **characterized in that** the alignment trenches (5) and contact holes (4) are filled with tungsten.

5. Method according to one of Claims 1 - 4, **characterized in that** the second metal layer (9) is composed of tungsten.

6. Method according to one of Claims 1 - 5, **characterized in that** the insulator layer (2) is composed of an oxide layer.

7. Method according to Claim 6, **characterized in that** the oxide layer is composed of SiO₂.

8. Method according to one of Claims 1 - 7, **characterized in that** the second metal layer (9) has a layer thickness of about 300 nm.

9. Method according to one of Claims 1 - 8, **characterized in that** the insulator layer (2) has a layer thickness of about 500 nm.

10. Method according to one of Claims 1 - 9, **characterized in that** the widths of the contact holes (4) are considerably less than the widths of the alignment trenches (5).

11. Method according to Claim 10, **characterized in that** the widths of the alignment trenches (5) are about 2 µm.

12. Method according to either of Claims 10 and 11, **characterized in that** the widths of the contact holes (4) are about 0.3 µm.

13. Method according to one of Claims 1 - 12, **characterized in that** the alignment markers are designed as alignment marks or as overlay marks.

14. Method according to one of Claims 1 - 13, **characterized in that** the alignment markers are arranged in the sawing frame of a wafer forming the semiconductor substrate 1.

15. Method according to Claim 14, **characterized in that** the alignment markers are used to effect alignment of a resist mask with the second metal layer (9).

16. Method according to Claim 15, **characterized in that** the alignment markers are used to determine the position error with respect to the plane with the contact holes (4).

17. Method according to one of Claims 1 - 16, **characterized in that** the integrated circuits in the semiconductor substrate (1) are formed by a DRAM cell arrangement.

## Revendications

1. Procédé de production de repères d'alignement dans une structure ayant des circuits intégrés, comprenant les stades suivants de procédé dans lesquels :
on dépose une première couche (3) métallique ayant une surface sur un substrat (1) semi-conducteur ayant des circuits intégrés ;
on dépose une couche (2) isolante sur la première couche (3) métallique, l'épaisseur de la couche (3) métallique étant sensiblement plus petite que l'épaisseur de la couche (2) isolante ;
on ménage par attaque des trous (4) de contact et des sillons (5) d'alignement dans la couche (2) isolante, les trous (4) de contact et les sillons (5) d'alignement débouchant sur leurs côtés inférieurs, respectivement, sur la première couche (3) métallique et les largeurs des sillons (5) d'alignement étant sensiblement plus grandes que les largeurs des trous (4) de contact ;
on comble de métal (6) les sillons (5) d'alignement et les trous (4) de contact et on traite ensuite la surface de la couche (2) isolante et du métal (6) par polissage chémiomécanique (CMP), les surfaces métalliques étant abaissées dans la zone des sillons (5) d'alignement et formant des profils pour les repères d'alignement ;
on dépose une deuxième couche (9) métallique sur la couche (2) isolante et sur le métal (6) en créant sur la face supérieure de la deuxième couche (9) métallique dans la zone des sillons (5) d'alignement correspondant aux profils respectifs des cavités (8) locales qui forment les repères d'alignement.

2. Procédé suivant la revendication 1, **caractérisé en ce que** le polissage chémiomécanique comprend une opération d'attaque dans laquelle on enlève une mince couche superficielle de la couche (2) isolante, de sorte que les surfaces métalliques dans la zone des trous (4) de contact sont légèrement en saillie au-dessus de la face supérieure de la couche (2) isolante.

3. Procédé suivant l'une des revendications 1 ou 2, **caractérisé en ce que** la première couche (3) métallique est en tungstène ou en AlCu.

4. Procédé suivant l'une des revendications 1 à 3, **caractérisé en ce que** les sillons (5) d'alignement et les trous (4) de contact sont comblés de tungstène.

5. Procédé suivant l'une des revendications 1 à 4, **caractérisé en ce que** la deuxième couche (9) métallique est en tungstène.

6. Procédé suivant l'une des revendications 1 à 5, **caractérisé en ce que** la couche (2) isolante est une couche d'oxyde.

7. Procédé suivant la revendication 6, **caractérisé en ce que** la couche d'oxyde est en SiO₂.

8. Procédé suivant l'une des revendications 1 à 7, **caractérisé en ce que** la deuxième couche (9) métallique a une épaisseur d'environ 300 nm.

9. Procédé suivant l'une des revendications 1 à 8, **caractérisé en ce que** la couche (2) isolante a une épaisseur d'environ 500 nm.

10. Procédé suivant l'une des revendications 1 à 9, **caractérisé en ce que** les largeurs des trous (4) de contact sont considérablement plus petites que les largeurs des sillons (5) d'alignement.

11. Procédé suivant la revendication 10, **caractérisé en ce que** les largeurs des sillons (5) d'alignement sont d'environ 2 µm.

12. Procédé suivant l'une des revendications 10 ou 11, **caractérisé en ce que** les largeurs des trous (4) de contact sont d'environ 3 µm.

13. Procédé suivant l'une des revendications 1 à 12, **caractérisé en ce que** les repères d'alignement sont constitués sous la forme d'alignement-mark ou d'overlay-mark.

14. Procédé suivant l'une des revendications 1 à 13, **caractérisé en ce que** les repères d'alignement sont disposés dans le cadre de sciage d'une tranche formant le substrat (1) semi-conducteur.

15. Procédé suivant la revendication 14, **caractérisé en ce que** l'on effectue au moyen des repères d'alignement un alignement d'un masque de vernis sur la deuxième couche (9) métallique.

16. Procédé suivant la revendication 15, **caractérisé en ce que** l'on détermine au moyen des repères d'alignement le défaut de position par rapport au plan ayant les trous (4) de contact.

17. Procédé suivant l'une des revendications 1 à 16, **caractérisé en ce que** les circuits intégrés dans le substrat (1) semi-conducteur sont formés par un dispositif de cellule DRAM.
